# EUROPEAN PATENT APPLICATION

(11) **EP 4 661 622 A1**
(43) Date of publication of application: **10.12.2025**
(21) Application number: 25175913.0
(22) Date of filing: 13.05.2025
(51) Int. Cl.: H10D 84/01, H10D 30/01, H10D 30/00, H10D 84/83, H10D 88/00, H10D 84/85, H10D 30/69, H10D 62/40

(54) **SEMICONDUCTOR DEVICE INCLUDING DIELECTRIC WALL APPLYING CHANNEL STRESS TO CHANNEL STRUCTURE**

(30) Priority: 05.06.2024 US 202463656380 P; 10.12.2024 US 202418975837
(71) Applicant: Samsung Electronics Co., Ltd., Suwon-si, Gyeonggi-do 16677 (KR)
(72) Inventor: SHIN, Hyo Jong, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a 1^{st} channel structure extended in a 1^{st} direction; a 1^{st} source/drain pattern on the 1^{st} channel structure; a 2^{nd} channel structure extended in the 1^{st} direction wherein the 2^{nd} channel structure is disposed at a side of the 1^{st} channel structure in a 2^{nd} direction intersecting the 1^{st} direction; a 2^{nd} source/drain pattern on the 2^{nd} channel structure; and a 1^{st} dielectric wall between the 1^{st} channel structure and the 2^{nd} channel structure. In a first alternative, the 1^{st} source/drain pattern and the 2^{nd} source/drain pattern are each of n-type, and a top surface of each of the 1^{st} channel structure and the 2^{nd} channel structure is in a (110) orientation and a side surface of each of the 1^{st} channel structure and the 2^{nd} channel structure is in a (100) orientation, respectively. In a second alternative, the 1^{st} source/drain pattern and the 2^{nd} source/drain pattern are each of p-type, wherein a top surface of each of the 1^{st} channel structure and the 2^{nd} channel structure is in a (100) orientation, and wherein a side surface of each of the 1^{st} channel structure and the 2^{nd} channel structure is in a (110) orientation.

## Description

### BACKGROUND

### 1. Field

Apparatuses and methods consistent with the disclosure relate to a semiconductor device including a dielectric wall applying channel stress to a channel structure of the semiconductor device.

### 2. Description of Related Art

A three-dimensional (3D) transistor structure has been introduced to achieve enhanced device performance and device density in manufacturing an integrated circuit. A fin field-effect transistor (FinFET) and a nanosheet transistor are known to be representative 3D transistors. The FinFET has one or more vertical fins, protruded from a substrate, as a channel structure of which at least three surfaces of each of the fins are surrounded by a gate structure, and the nanosheet transistor is characterized by one or more nanosheet channel layers, vertically stacked on a substrate, as a channel structure and a gate structure surrounding all four surfaces of each of the nanosheet channel layers. The nanosheet transistor is referred to as gate-all-around (GAA) transistor, or as a multi-bridge channel field-effect transistor (MBCFET).

Further, a forksheet transistor has been introduced as an application of the nanosheet transistor to further increase device density. The forksheet transistor is a combination of two nanosheet transistors with a dielectric wall therebetween. Nanosheet channel layers of each nanosheet transistor of the forksheet transistor are formed at each side of the dielectric wall and pass through a gate structure in parallel with the dielectric wall. In addition to the requirements for increased device density, demand for improved device performance in a semiconductor device formed of forksheet transistors has also increased. Channel stress based on which mobility of carriers, that is, electrons or holes, increases or decreases may determine performance of the forksheet transistor.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a forksheet transistor in which a dielectric wall is formed of a material that can exert a compressive stress or a tensile stress to a channel structure in a channel-width direction depending on a polarity type of a nanosheet transistor forming the forksheet transistor, and a channel surface orientation of the nanosheet transistor.

According to an aspect of the disclosure, there is provided a semiconductor device which may include: a 1^{st} channel structure extended in a 1^{st} direction; a 1^{st} source/drain pattern on the 1^{st} channel structure; a 2^{nd} channel structure extended in the 1^{st} direction, wherein the 2^{nd} channel structure is disposed at a side of the 1^{st} channel structure in a 2^{nd} direction intersecting the 1^{st} direction; a 2^{nd} source/drain pattern on the 2^{nd} channel structure; and a 1^{st} dielectric wall between the 1^{st} channel structure and the 2^{nd} channel structure, wherein the 1^{st} source/drain pattern and the 2^{nd} source/drain pattern are each of n-type, and wherein a top surface and a side surface of each of the 1^{st} channel structure and the 2^{nd} channel structure is in a (110) orientation and in a (100) orientation, respectively.

According to an aspect of the disclosure, there is provided a semiconductor device which may include: a 1^{st} channel structure extended in a 1^{st} direction; a 1^{st} source/drain pattern on the 1^{st} channel structure; a 2^{nd} channel structure extended in the 1^{st} direction, wherein the 2^{nd} channel structure is disposed at a side of the 1^{st} channel structure in a 2^{nd} direction intersecting the 1^{st} direction; a 2^{nd} source/drain pattern on the 2^{nd} channel structure; and a dielectric wall between the 1^{st} channel structure and the 2^{nd} channel structure, wherein the 1^{st} source/drain pattern and the 2^{nd} source/drain pattern are each of p-type, and wherein a top surface and a side surface of each of the 1^{st} channel structure and the 2^{nd} channel structure is in a (100) orientation and in a (110) orientation, respectively.

According to an aspect of the disclosure, there is provided a semiconductor device which may include: a 1^{st} channel structure extended in a 1^{st} direction; a 1^{st} source/drain pattern on the 1^{st} channel structure; a 2^{nd} channel structure extended in the 1^{st} direction, wherein the 2^{nd} channel structure is disposed at a side of the 1^{st} channel structure in a 2^{nd} direction intersecting the 1^{st} direction; a 2^{nd} source/drain pattern on the 2^{nd} channel structure; and a dielectric wall between the 1^{st} channel structure and the 2^{nd} channel structure, wherein the 1^{st} source/drain pattern and the 2^{nd} source/drain pattern are of a same polarity type.

According to an aspect of the disclosure, there is provided a semiconductor cell which may include: a 1^{st} nanosheet transistor of p-type of which a channel structure contacts a 1^{st} dielectric wall; and a 2^{nd} nanosheet transistor of n-type of which a channel structure contacts a 2^{nd} dielectric wall, wherein the 1^{st} dielectric wall forms a 1^{st} boundary of the semiconductor cell and the 2^{nd} dielectric wall forms a 2^{nd} boundary of the semiconductor cell, opposite to the 1^{st} boundary.

According to an aspect of the disclosure, there is provided a semiconductor cell which may include: a 1^{st} channel structure; a 2^{nd} channel structure at a side of the 1^{st} channel structure; a 1^{st} dielectric wall between the 1^{st} channel structure and the 2^{nd} channel structure; a 3^{rd} channel structure above the 1^{st} channel structure; a 4^{th} channel structure above the 2^{nd} channel structure and at a side of the 3^{rd} channel structure; a 2^{nd} dielectric wall between the 3^{rd} channel structure and the 4^{th} channel structure, wherein the 1^{st} dielectric wall and the 2^{nd} dielectric wall comprise different materials or different material compositions.

### BRIEF DESCRIPTION OF DRAWINGS

Example embodiments of the disclosure will be more clearly understood from the following detailed description taken in conjunction with the accompanying drawings.
FIG. 1 illustrates a schematic of a nanosheet transistor.
FIGS. 2A and 2B illustrate a schematic of a forksheet transistor, according to one or more embodiments.
FIGS. 3A and 3B each illustrates schematics of one of a plurality of channel layers of a nanosheet transistor forming a forksheet transistor, according to one or more embodiments.
FIG. 4A illustrates a cross-section view of the forksheet transistor of FIG. 2A along a line I-I' when two nanosheet transistors forming the forksheet transistor are each an NMOS, according to one or more embodiments.
FIG. 4B illustrates a cross-section view of the forksheet transistor of FIG.2A along a line I-I' when two nanosheet transistors forming the forksheet transistor are each an PMOS, according to one or more embodiments.
FIG. 5 illustrates a cross-section view of the forksheet transistor of FIG. 2A along a line I-I' when two nanosheet transistors forming the forksheet transistor are each an NMOS, according to one or more other embodiments.
FIG. 6 illustrates a cross-section view of the forksheet transistor of FIG. 2A along a line I-I' when two nanosheet transistors forming the forksheet transistor are each an PMOS, according to one or more other embodiments.
FIGS. 7A-7D illustrate 3D-stacked semiconductor devices in each of which two forksheet transistors having respective channel surface orientations are stacked in the 3^{rd} direction D3, according to one or more embodiments.
FIGS. 8A and 8B illustrates semiconductor cells each of which is formed of two forksheet transistors, according to one or more embodiments.
FIG. 9 is a schematic block diagram illustrating an electronic device including at least one of the forksheet transistors shown in FIGS. 2A, 2B, 3A, 3B, 4A, 4B, 5 and 6, the 3D-stacked semiconductor device shown in FIG. 7, and the semiconductor cell shown in FIG. 8, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiments could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

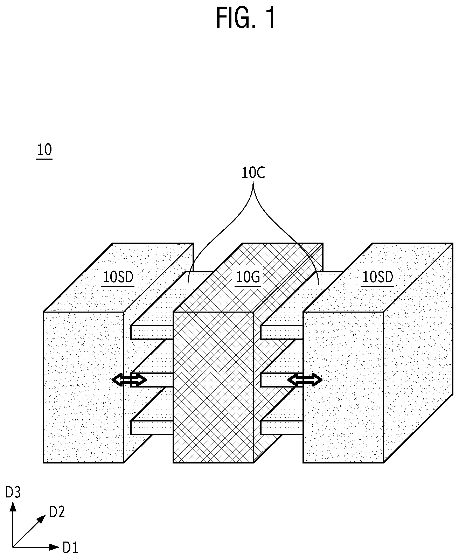

FIG. 1 illustrates a schematic of a nanosheet transistor.

Referring to FIG. 1, a nanosheet transistor 10 includes a channel structure formed of a plurality of channel layers 10C extended in a 1^{st} direction D1, a gate structure 10G extended in a 2^{nd} direction D2 and surrounding the channel layers 10C, and source/drain patterns 10SD connected by the channel layers 10C. The channel layers 10C may be arranged or stacked in a 3^{rd} direction D3. Here, the 1^{st} direction D1 refers to a channel-length direction or a current-flow direction in which a current flows between the source/drain patterns 10SD when the nanosheet transistor 10 is powered. The 2^{nd} direction D2 refers to a channel-width direction intersecting the 1^{st} direction D1. The 2^{nd} direction D2 is also referred to as a cell height direction when the nanosheet transistor 10 is implemented in a semiconductor cell (or a standard cell) to form a logic circuit with one or more other circuit elements. The 3^{rd} direction D3 is a channel thickness or height direction intersecting the 1^{st} direction D1 and the 2^{nd} direction D2.

The channel layers 10C may have been epitaxially grown in the 3^{rd} direction D3 from a substrate formed of silicon (Si), and thus, may also be formed of Si. Each of the channel layers 10C is a nanosheet layer of which a top surface and a bottom surface are each wider than a side surface.

The gate structure 10G may include a gate dielectric layer and a gate metal structure. The gate dielectric layer may be formed to surround the top surface, the bottom surface and the two side surfaces of each of the channel layers 10C. The gate dielectric layer may include a high-k material such as hafnium oxide (HfO₂), hafnium silicate (HfSiO₄), titanium oxide (TiO₂), zirconium oxide (ZrO₂), aluminum oxide (Al₂O₃), lanthanum oxide (La₂O₃), yttrium oxide (Y₂O₃), etc., not being limited thereto, to suppress leakage of a gate current to the channel layers 10C. The gate metal structure may include a work-function metal layer formed on the gate dielectric layer and a gate electrode formed on the work-function metal layer. The work-function metal layer controlling a gate threshold voltage may be formed of a metal or a metal compound such as titanium (Ti), tantalum (Ta), TiN, WN, TiAl, TiAlN, TaN, TiC, TaC, TiAlC, TaCN, TaSiN, and/or a combination thereof, not being limited thereto. The gate electrode receiving a gate input signal may be formed of a metal such as copper (Cu), tungsten (W), aluminum (Al), cobalt (Co), and/or a combination thereof, not being limited thereto.

The source/drain patterns 10SD may be formed of silicon (Si). For the nanosheet transistor 10 to form a p-type transistor, the source/drain patterns 10SD may be in-situ doped with impurities such as boron (B), gallium (Ga), indium (In), etc. when the source/drain patterns 10SD are epitaxially grown from the channel layers 10C. In contrast, for the nanosheet transistor 10 to form an n-type transistor, the source/drain patterns 10SD may be in-situ doped with impurities such as phosphorus (P), arsenic (As), antimony (Sb), etc.

Further, in order to boost carrier (hole or electron) mobility, thereby to drive current increase through the channel layers 10C, the source/drain patterns 10SD may be configured to apply a stress (or strain) to the channel layers 10C in the 1^{st} direction D1 (channel-length, current-flow or longitudinal direction). Thus, in a case where the nanosheet transistor 10 is to form a p-type metal-oxide-semiconductor transistor (PMOS), the source/drain patterns 10SD may be configured to apply a compressive stress to the channel layers 10C in the 1^{st} direction D1 to increase hole mobility through the channel layers 10C. For this purpose, the source/drain patterns 10SD may be formed of, for example, silicon germanium (SiGe), and, by controlling the Ge concentration in the source/drain patterns 10SD, a level of compressive stress in the 1^{st} direction D1 can be adjusted to optimize device performance. In contrast, in a case where the nanosheet transistor 10 is to form an n-type metal-oxide-semiconductor transistor (NMOS), the source/drain patterns 10SD may be configured to apply a tensile stress to the channel layers 10C in the 1^{st} direction D1 to increase electron mobility through the channel layers 10C. For this purpose, the source/drain patterns 10SD may be formed of, for example, silicon carbon (SiC), and, by controlling the carbon (C) concentration in the source/drain patterns 10SD, a level of tensile stress can be adjusted to optimize device performance.

However, the nanosheet transistor 10 may be limited in applying the channel stress, whether it is a compressive stress or a tensile stress, to the channel layers 10C only in the 1^{st} direction D1 as indicated by arrows shown in FIG. 1, but not the 2^{nd} direction D2 (channel-width or transverse direction). This is at least because the top surface, the bottom surface and the two side surfaces of the channel layers 10C are surrounded by the gate structure 10G.

In the meantime, as described in the study by Kyoungsub Shin et al., titled "Dual Stress Capping Layer Enhancement Study for Hybrid Orientation FinFET CMOS Technology" (IEDM, 2005, DOI: 10.1109; hereafter "Conference Paper"), carrier mobility may also be controlled when a predetermined channel stress is applied to a channel structure of a FinFET, which is a vertical fin structure, in the 2^{nd} direction D2 and the 3^{rd} direction D3 as well as the 1^{st} direction D1 subject to a channel surface orientation.

Thus, referring to the channel stress direction and carrier mobility in the Conference Paper, the inventors of the present application have invented the following embodiments of a transistor structure in which a channel stress is applied to a channel structure of a transistor in the 2^{nd} direction D2 as well as the 1^{st} direction D1 depending on a channel surface orientation.

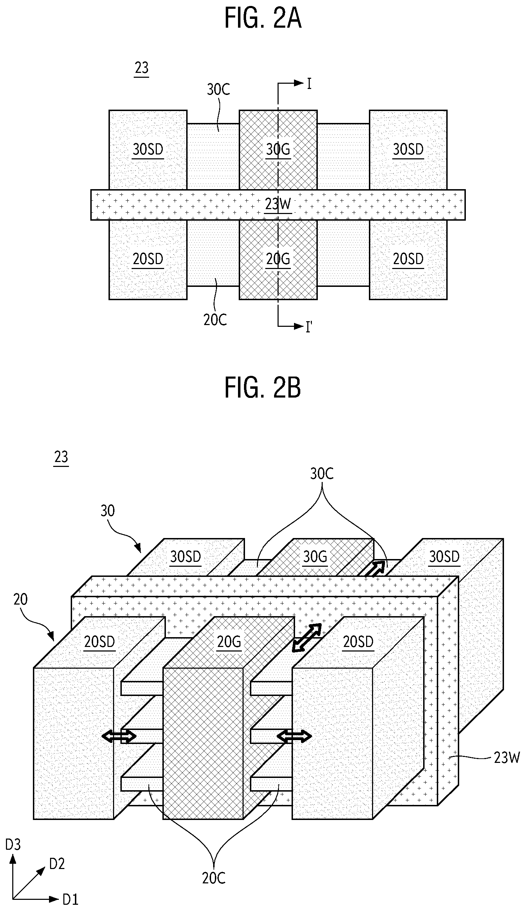

FIGS. 2A and 2B illustrate a schematic of a forksheet transistor, according to one or more embodiments. FIG. 2A is a top plan view of the forksheet transistor, and FIG. 2B is a perspective view of the forksheet transistor.

Referring to FIGS. 2A and 2B, a forksheet transistor 23 may include a 1^{st} nanosheet transistor 20 and a 2^{nd} nanosheet transistor 30 with a dielectric wall 23W therebetween. Each of the two nanosheet transistors 20 and 30 may be formed of the same structural elements of the nanosheet transistor structure 10 shown in FIG. 1. For example, the 1^{st} nanosheet transistor 20 may include a channel structure formed of a plurality of channel layers 20C, a gate structure 20G, and source/drain patterns 20SD, which may be the same as the corresponding structural elements of the nanosheet transistor 10 of FIG. 1. Further, the 2^{nd} nanosheet transistor 30 may include a channel structure formed of a plurality of channel layers 30C, a gate structure 30G, and source/drain patterns 30SD, which may be the same as the corresponding structural elements of the nanosheet transistor 10 of FIG. 1. Thus, duplicate descriptions thereof may be omitted while the same reference characters or numerals are used in describing the forksheet transistor 20 herebelow.

The forksheet transistor 23 may be characterized by the dielectric wall 23W which is extended in the 1^{st} direction to isolate the two nanosheet transistors 20 and 30 from each other and reduce capacitance that may be generated by proximity of the two transistors. One side surface of the dielectric wall 23W may face and contact, in the 2^{nd} direction D2, a side surface of each of the channel layers 20C not surrounded by the gate structure 20G, a side surface of the gate structure 20G, and a side surface of each of the source/drain patterns 20SD of the 1^{st} nanosheet transistor 20. Likewise, the other side surface of the dielectric wall 23W may face and contact, in the 2^{nd} direction D2, a side surface of each of the channel layers 30C not surrounded by the gate structure 30G, a side surface of the gate structure 30G, and a side surface of each of the source/drain patterns 30SD of the 2^{nd} nanosheet transistor 30. Thus, the dielectric wall 23W may be used as a stress structure that may apply a channel stress to the channel layers 20C and 30C of the forksheet transistor 23 in the 2^{nd} direction D2. For example, the dielectric wall 23W may be formed of a material(s) that can apply a channel stress to the channel layers 20C and 30C in the 2^{nd} direction D2 as indicated by arrows in FIGS. 2A and 2B.

In a related art, a forksheet transistor structure may be formed of a PMOS nanosheet transistor and an NMOS nanosheet transistor with a dielectric wall therebetween to constitute a logic circuit such as a complementary metal-oxide-semiconductor device (CMOS) device (e.g., inverter circuit) in a semiconductor cell. However, in the forksheet transistor 23 shown in FIGS. 2A and 2B, the two nanosheet transistors 20 and 30 may both be a same polarity type of transistor, that is, either a p-type (PMOS) or an n-type (NMOS), so that the compressive stress or tensile stress can be applied to both transistors of the same polarity type to increase carrier mobility in the 2^{nd} direction D2.

For example, the dielectric wall 23W may be formed of a compressive material such as silicon oxide (e.g., SiO or SiO₂), not being limited thereto, while the channel layers 20C and 30C of the two nanosheet transistors 20 and 30 are formed of silicon (Si). For example, SiO or SiO₂ of the dielectric wall 23W has a lower thermal expansion coefficient than Si of the channel layers 20C and 30C, by which a thermal expansion mismatch may occur therebetween when the dielectric wall 23W is formed to divide an initial channel structure into the channel layers 20C and the channel layers 30C, for example, through chemical vapor deposition (CVD). Thus, in a case where the dielectric wall 23W is formed of a compressive material such as SiO or SiO₂, a tensile stress may be applied to or induced in the channel layers 20C and 30C of Si which contacts the dielectric wall 23W in the 2^{nd} direction D2 in addition to a tensile stress or a compressive stress applied in the 1^{st} direction D1 by the source/drain patterns 20SD and 30SD, thereby further increasing carrier mobility in the forksheet transistor 23.

In contrast, the dielectric wall 23W may be formed of a tensile material such as silicon nitride (e.g., SiN or Si₃N₄), not being limited thereto, which has a greater thermal expansion coefficient than Si of the channel layers 20C and 30C, and thus, can generate a thermal expansion mismatch therebetween when the dielectric wall 20W is formed to divide an initial channel structure including the channel layers 20C and 30C, for example, through CVD. Thus, in a case where the dielectric wall 23W is formed of a tensile material such as SiN or Si₃N₄, a compressive stress may be applied to the channel layers 20C and 30C of Si which contacts the dielectric wall 23W in the 2^{nd} direction D2 in addition to a tensile stress or a compressive stress applied in the 1^{st} direction D1 by the source/drain patterns 20SD and 30SD, thereby further increasing carrier mobility in the forksheet transistor 23.

The foregoing embodiments of applying a channel stress by a dielectric wall in a forksheet transistor may be extended by considering a polarity type (p-type or n-type) and channel surface orientation of each of two nanosheet transistors forming the forksheet transistor, as described below, according to one or more embodiments.

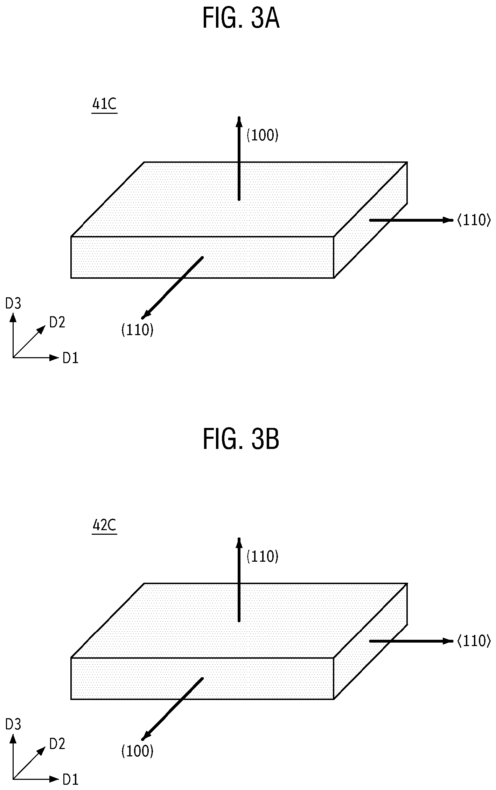

FIGS. 3A and 3B each illustrates schematics of one of a plurality of channel layers of a nanosheet transistor forming a forksheet transistor, according to one or more embodiments.

Referring to FIGS. 3A and 3B, a channel layer 41C and a channel layer 42C may each be the same as or correspond to the channel layer 20C or 30C of the forksheet transistor 23 of FIGS. 2A and 2B, and thus, each of the channel layers 41C and 42C may have the same material and structural characteristics of the channel layer 20C or 30C of the forksheet transistor 23. Thus, duplicate descriptions thereof may be omitted herein.

However, the channel layers 41C and 42C may have different surface orientations from each other as shown in FIGS. 3A and 3B. For example, the channel layer 41C may have a top surface in the (100) orientation, a side surface in the (110) orientation, and a channel length for current flow in the <110> direction. For an NMOS nanosheet transistor, electron mobility is highest when a top surface of the channel is in the (100) orientation. Thus, a channel structure of an NMOS nanosheet transistor may take the form of FIG. 3A to achieve an improved device performance. In contrast, the channel layer 42C may have a top surface in the (110) orientation, a side surface in the (100) orientation, and a channel length for current flow in the <110> direction. For a PMOS nanosheet transistor (PMOS), hole mobility is highest when a top surface of the channel is in the (110) orientation. Thus, a channel structure of an PMOS nanosheet transistor may take the form of FIG. 3B to achieve an improved device performance.

Further, in a case where a nanosheet transistor including the channel layer 41C is an NMOS, a tensile stress applied to the channel layer 41C in the 2^{nd} direction D2 may increase electron mobility, and also, in a case where the nanosheet transistor including the channel layer 41C is a PMOS, a tensile stress applied to the channel layer 41C in the 2^{nd} direction D2 may increase hole mobility. Thus, regardless of the polarity type of the nanosheet transistor including the channel layer 41C, a tensile stress applied to the channel layer 41C in the 2^{nd} direction D2 may further increase carrier mobility when the top surface and the side surface of the channel layer 41C is in the (100) orientation and the (110) orientation, respectively. Here, it is understood that even if the channel surface orientation of the channel layer 41C provides better electron mobility for an NMOS nanosheet transistor than hole mobility for a PMOS nanosheet transistor, this channel surface orientation may be adopted for channel layers of the PMOS nanosheet transistor as a tensile stress applied to the channel layer 41C in the 2^{nd} direction D2 increases hole mobility.

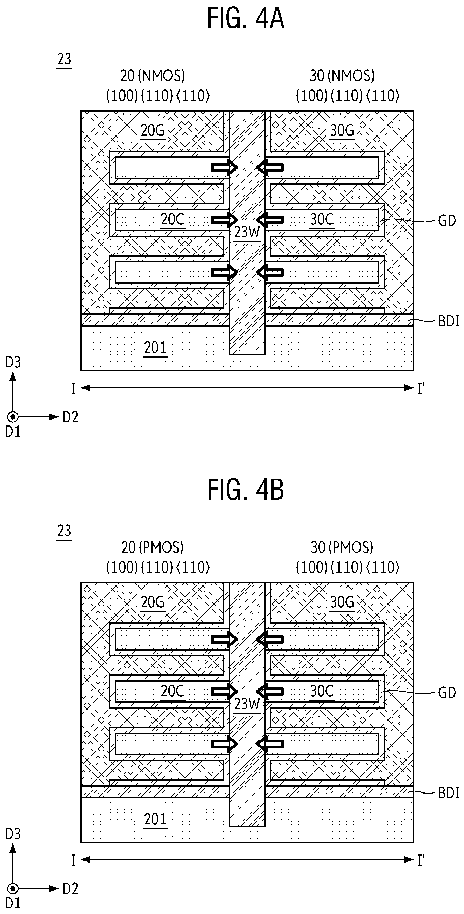

Accordingly, whether the nanosheet transistors 20 and 30 of the forksheet transistor 23 of FIGS. 2A and 2B are each an NMOS or a PMOS in which each of the channel layers 20C and 30C has the same channel surface orientation of the channel layer 41C, a tensile stress applied to the channel layers 20C and 30C in the 2^{nd} direction D2 may further increase carrier mobility, thereby improving device performance. For this purpose, the dielectric wall 23W of the forksheet transistor 23 may be formed of a compressive material such as silicon oxide (e.g., SiO or SiO₂), not being limited thereto, to induce a tensile stress in the channel layers 20C and 30C in the 2^{nd} direction D2, as described above in reference to FIGS. 2A and 2B. For example, the forksheet transistor 23 may take the structural forms shown in FIGS. 4A and 4B.

FIG. 4A illustrates a cross-section view of the forksheet transistor 23 along a line I-I' shown in FIG. 2A when the two nanosheet transistors 20 and 30 forming the forksheet transistor 23 are each an NMOS, according to one or more embodiments. FIG. 4B illustrates a cross-section view of the forksheet transistor 23 along a line I-I' shown in FIG. 2A when the two nanosheet transistors 20 and 30 forming the forksheet transistor 23 are each a PMOS, according to one or more embodiments.

Referring to FIG. 4A, the forksheet transistor 23 may include the dielectric wall 23W which may be formed of a compressive material such as silicon oxide, not being limited thereto, which induces a tensile stress in the channel layers 20C and 30C in the 2^{nd} direction D2 when each of the nanosheet transistors 20 and 30 is an NMOS. Referring to FIG. 4B, even when each of the nanosheet transistors 20 and 30 is a PMOS, the dielectric wall 23W may be formed of the same compressive material as silicon oxide, not being limited thereto, to induce a tensile stress in the channel layers 20C and 30C in the 2^{nd} direction D2. FIGS. 4A and 4B further show that the forksheet transistor 23 includes a substrate 201, on which the channel layers 20C and 30C are formed, a gate dielectric layer GD surrounding the channel layers 20C and 30C, and a bottom dielectric BDI that isolates a substrate 201 from the gate structures 20G and 30G.

In contrast, in a case in which a nanosheet transistor including the channel layer 42C is an NMOS, a tensile stress applied to the channel layer 42C in the 2^{nd} direction D2 may decrease electron mobility. However, in the same case, a compressive stress applied to the channel layer 42C in the 2^{nd} direction D2 may increase electron mobility. Thus, when the top surface and the side surface of the channel layer 42C is in the (110) orientation and the (100) orientation, respectively, in an NMOS nanosheet transistor, a compressive stress applied to the channel layer 42C in the 2^{nd} direction D2 may further increase electron mobility. Here, it is understood that even if the channel surface orientation of the channel layer 42C provides better hole mobility for a PMOS nanosheet transistor than electron mobility for an NMOS nanosheet transistor, this channel surface orientation may be adopted for channel layers of the NMOS nanosheet transistor as a compressive stress applied to the channel layer 42C in the 2^{nd} direction D2 increases electron mobility.

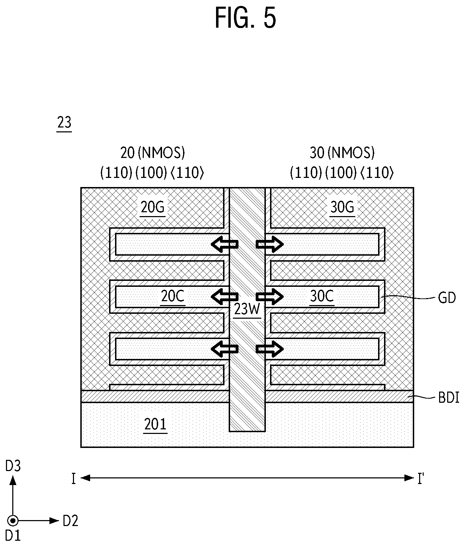

Accordingly, when the nanosheet transistors 20 and 30 of the forksheet transistor 23 of FIGS. 2A and 2B are each an NMOS in which each of the channel layers 20C and 30C has the same channel surface orientation of the channel layer 42C, a compressive stress applied to the channel layers 42C in the 2^{nd} direction D2 may further increase electron mobility, thereby improving device performance. For this purpose, the dielectric wall 23W of the forksheet transistor 23 may be formed of a tensile material such as silicon nitride (e.g., SiN or Si₃N₄), not being limited thereto, as described above in reference to FIGS. 2A and 2B . For example, the forksheet transistor 23 may take the following structural form shown in FIG. 5.

FIG. 5 illustrates a cross-section view of the forksheet transistor 23 along a line I-I' shown in FIG. 2A when the two nanosheet transistors 20 and 30 forming the forksheet transistor 23 are each an NMOS, according to one or more other embodiments. Referring to FIG. 5, the forksheet transistor 23 may include the dielectric wall 23W which may be formed of a tensile material such as silicon nitride, not being limited thereto, which applies a compressive stress to the channel layers 20C and 30C in the 2^{nd} direction D2 when each of the nanosheet transistors 20 and 30 is an NMOS.

In the meantime, in a case where a nanosheet transistor including the channel layer 42C is a PMOS, a compressive stress applied to the channel layer 42C in the 2^{nd} direction D2 may decrease hole mobility. However, in the same case, a tensile stress applied to the channel layer 42C in the 2^{nd} direction D2 may increase hole mobility. Thus, when the top surface and the side surface of the channel layer 42C is in the (110) orientation and the (100) orientation, respectively, in a PMOS nanosheet transistor, a tensile stress applied to the channel layer 42C in the 2^{nd} direction D2 may further increase hole mobility.

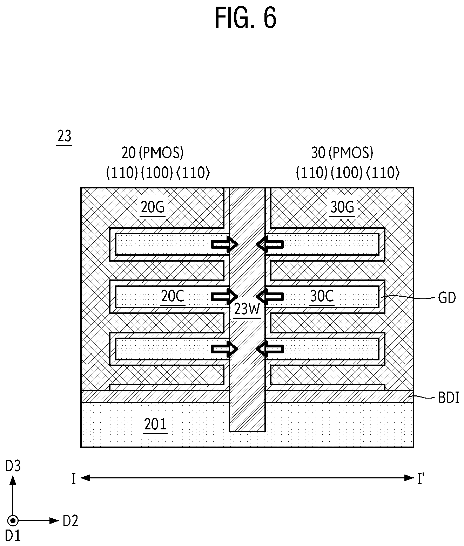

Accordingly, when the nanosheet transistors 20 and 30 of the forksheet transistor 23 of FIGS. 2A and 2B are each a PMOS in which each of the channel layers 20C and 30C has the same channel surface orientation of the channel layer 42C, a tensile stress applied to the channel layers 42C in the 2^{nd} direction D2 may further increase hole mobility, thereby improving device performance. For this purpose, the dielectric wall 23W of the forksheet transistor 23 may be formed of a compressive material such as silicon oxide, not being limited thereto, as described above in reference to FIGS. 2A and 2B. For example, the forksheet transistor 23 may take the following structural form shown in FIG. 6.

FIG. 6 illustrates a cross-section view of the forksheet transistor 23 along a line I-I' shown in FIG. 2A when the two nanosheet transistors 20 and 30 forming the forksheet transistor 23 are each a PMOS, according to one or more other embodiments. Referring to FIG. 6, the forksheet transistor 23 may include the dielectric wall 23W which may be formed of a compressive material such as silicon oxide, not being limited thereto, which applies a tensile stress to the channel layers 20C and 30C in the 2^{nd} direction D2 when each of the nanosheet transistors 20 and 30 is an PMOS.

In the above embodiments, silicon oxide is taken as an example of the compressive material, and silicon nitride is taken as an example of the tensile material. However, other materials having an amorphous structure and a lower thermal expansion coefficient than the material forming the channel structure (e.g., silicon) may be used as a compressive material for a dielectric wall of a forksheet transistor to apply a tensile stress to a channel structure of the forksheet transistor. Likewise, other materials having an amorphous structure and a greater thermal expansion coefficient than the material forming the channel structure may be used as a tensile material for the dielectric wall of the forksheet transistor to apply a compressive stress to the channel structure.

The foregoing embodiments of applying a channel stress through a dielectric wall in a forksheet transistor may be extended to a three-dimension (3D) stacked semiconductor device in which two or more forksheet transistors are stacked in the 3^{rd} direction D3.

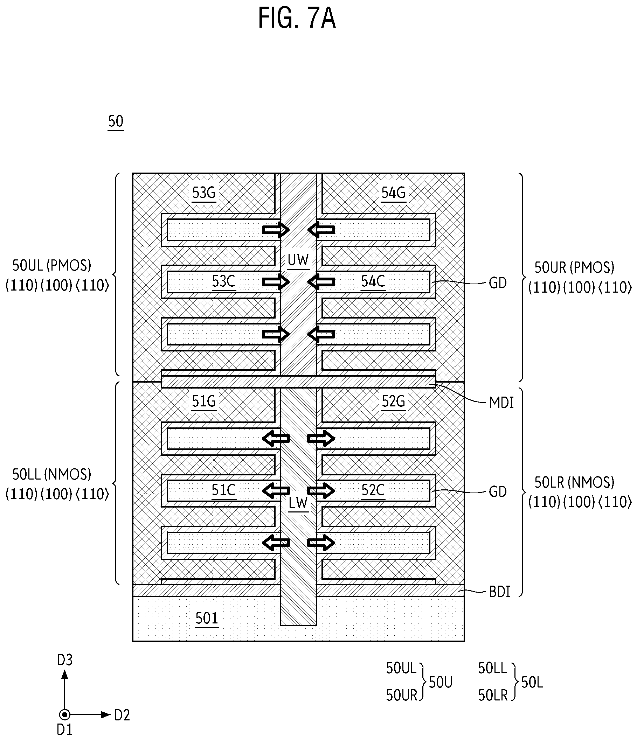

FIGS. 7A-7D illustrate 3D-stacked semiconductor devices in each of which two forksheet transistors having respective channel surface orientations are stacked in the 3^{rd} direction D3, according to one or more embodiments.

Referring to FIG. 7A, a 3D-stacked semiconductor device 50 may include a 1^{st} forksheet transistor 50L formed of NMOS nanosheet transistors 50LL and 50LR on a substrate 501 and a 2^{nd} forksheet transistor 50U formed of PMOS nanosheet transistors 50UL and 50UR, which are respectively stacked above the NMOS nanosheet transistors 50LL and 50LR with a middle dielectric isolation (MDI) layer therebetween.

The 1^{st} forksheet transistor 50L may be the same as or correspond to the forksheet transistor 23 shown in FIG. 5 with the top surface and the side surface of the channel layers in the (110) orientation and in the (100) orientation, respectively, and the 2^{nd} forksheet transistor 50U may be the same as or correspond to the forksheet transistor 23 shown in FIG. 6 with the top surface and the side surface of the channel layers also in the (110) orientation and in the (100) orientation, respectively. This combination of forksheet transistors 50L and 50U having the same channel surface orientation may be provided to facilitate a manufacture process of the 3D-stacked semiconductor device 50. For example, when the 3D-stacked semiconductor device 50 is manufactured, an initial channel structure for the channel layers 51C and 52C and an initial channel structure for the channel layers 53C and 54C may be epitaxially grown based on the substrate 501 in a simple monolithic process.

Still, however, a dielectric wall LW of the 1^{st} forksheet transistor 50L dividing channel layers 51C and 52C respectively surrounded by gate structures 51G and 52G may be formed of a tensile material such as silicon nitride that can apply a compressive stress to the channel layers 51C and 52C of silicon (Si) in the 2^{nd} direction D2 to improve electron mobility as described above in reference to FIG. 5. Further, a dielectric wall UW of the 2^{nd} forksheet transistor 50U dividing channel layers 53C and 54C respectively surrounded by gate structures 53G and 54G may be formed of a compressive material such as silicon oxide that can apply a tensile stress to the channel layers 53C and 54C of Si in the 2^{nd} direction D2 to improve hole mobility as described above in reference to FIG. 6.

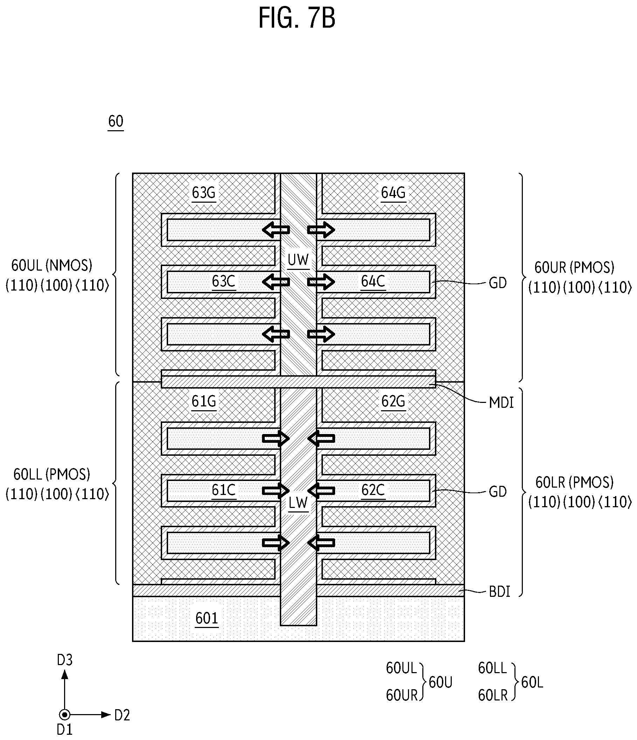

In the 3D-stacked semiconductor device 50 shown in FIG. 7A, the 1^{st} forksheet transistor 50L of n-type is formed at a lower stack and the 2^{nd} forksheet transistor 50U of p-type is formed at an upper stack. However, the disclosure is not limited thereto. According to one or more other embodiments, a 3D-stacked semiconductor device may be formed such that the 1^{st} forksheet transistor 50L of n-type is formed at the upper stack, and the 2^{nd} forksheet transistor 50U is formed at the lower stack, as shown in FIG. 7B.

Referring to FIG. 7B, a 3D-stacked semiconductor device 60 may include a 1^{st} forksheet transistor 60L formed of PMOS nanosheet transistors 60LL and 60LR on a substrate 601 and a 2^{nd} forksheet transistor 60U formed of NMOS nanosheet transistors 60UL and 60UR, which are respectively stacked above the PMOS nanosheet transistors 60LL and 60LR with an MDI layer therebetween.

The 1^{st} forksheet transistor 60L may be the same as or correspond to the forksheet transistor 23 shown in FIG. 6, and the 2^{nd} forksheet transistor 60U may be the same as or correspond to the forksheet transistor 23 shown in FIG. 5. Thus, when the 3D-stacked semiconductor device 60 is manufactured, an initial channel structure for the channel layers 61C and 62C and an initial channel structure for the channel layers 63C and 64C may be epitaxially grown based on the substrate 601 in a simple monolithic process.

Still, however, a dielectric wall LW of the 1^{st} forksheet transistor 60L dividing channel layers 61C and 62C respectively surrounded by gate structures 61G and 62G may be formed of a compressive material such as silicon oxide that can apply a tensile stress to the channel layers 61C and 62C of Si in the 2^{nd} direction D2 to improve hole mobility as described above in reference to FIG. 6. Further, a dielectric wall UW of the 2^{nd} forksheet transistor 60U dividing channel layers 63C and 64C respectively surrounded by gate structures 63G and 64G may be formed of a tensile material such as silicon nitride that can apply a compressive stress to the channel layers 63C and 64C of Si in the 2^{nd} direction D2 to improve electron mobility as described above in reference to FIG. 5.

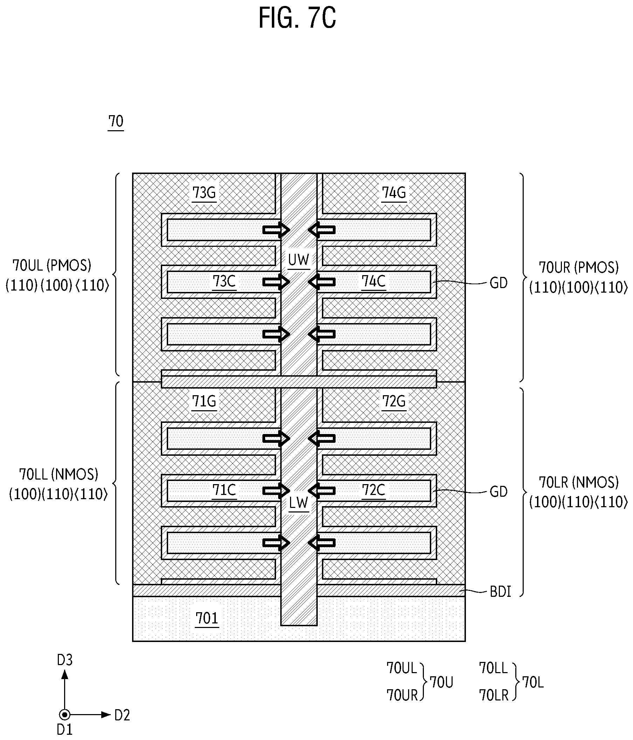

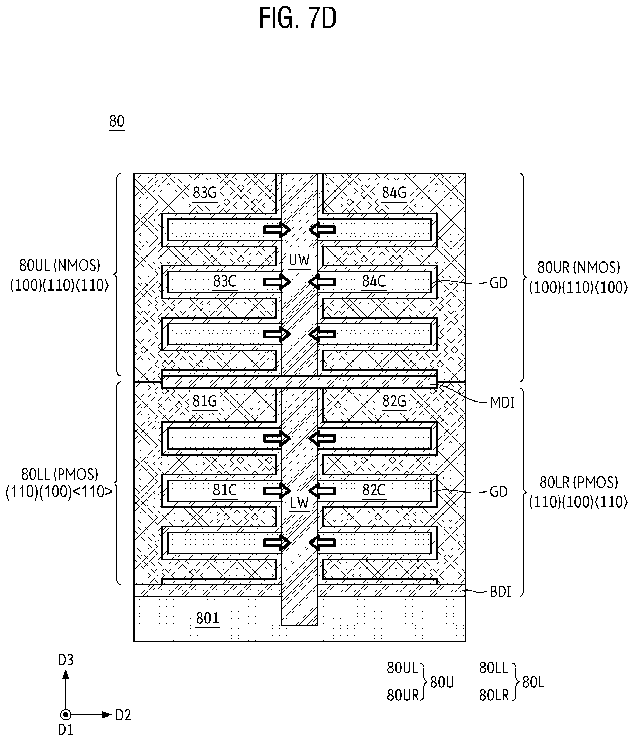

In the 3D-stacked semiconductor devices 50 and 60 above, the channel surface orientation of the forksheet transistors at the lower stack and the upper stack are the same. However, the disclosure is not limited thereto. According to one or more other embodiments, the forksheet transistors forming a 3D-stacked semiconductor device may have different channel surface orientations as shown in FIGS. 7C and 7D.

Referring to FIG. 7C, a 3D-stacked semiconductor device 70 may include a 1^{st} forksheet transistor 70L formed of NMOS nanosheet transistors 70LL and 70LR on a substrate 701 and a 2^{nd} forksheet transistor 70U formed of PMOS nanosheet transistors 70UL and 70UR, which are respectively stacked above the NMOS nanosheet transistors 70LL and 70LR with an MDI layer therebetween.

The 1^{st} forksheet transistor 70L may be the same as or correspond to the forksheet transistor 23 shown in FIG. 4A with the top surface and the side surface of the channel layers in the (100) orientation and in the (110) orientation, respectively. The 2^{nd} forksheet transistor 70U may be the same as or correspond to the forksheet transistor 23 shown in FIG. 6 with the top surface and the side surface of the channel layers in the (110) orientation and in the (100) orientation, respectively. This combination of forksheet transistors 70L and 70U may be provided considering that the NMOS nanosheet transistor 23 shown in FIG. 4A has a channel surface orientation enabling the highest electron mobility, and the PMOS transistor 23 shown in FIG. 6 has a channel surface orientation enabling the highest hole mobility. In this case, both of a dielectric wall LW dividing channel layers 71C and 72C respectively surrounded by gate structures 71G and 72G and a dielectric wall UW dividing channel layers 73C and 74C respectively surrounded by gate structures 73G and 74G may be formed of a compressive material such as silicon oxide that can apply a tensile stress to the channel layers 71C, 72C, 73C and 74C of Si in the 2^{nd} direction D2 to improve carrier mobility.

Here, however, the channel layers 71C and 72C of the 1^{st} forksheet transistor 70L may have a top surface in the (100) orientation and a side surface in the (110) orientation, while the channel layers 73C and 74C of the 2^{nd} forksheet transistor 70U may have a top surface in the (110) orientation and a side surface in the (100) orientation. Thus, when the 3D-stacked semiconductor device 70 is manufactured, an initial channel structure for the channel layers 71C and 72C and an initial channel structure for the channel layers 73C and 74C may be epitaxially grown based on respective substrates in separate processes, and then, the two forksheet transistors 70L and 70R may be combined to form the 3D-stacked semiconductor device 70.

In the 3D-stacked semiconductor device 70 shown in FIG. 7C, the 1^{st} forksheet transistor 70L of n-type is formed at a lower stack and the 2^{nd} forksheet transistor 70U of p-type is formed at an upper stack. However, the disclosure is not limited thereto. According to one or more other embodiments, a 3D-stacked semiconductor device may be formed such that the 1^{st} forksheet transistor 70L of n-type is formed at the upper stack, and the 2^{nd} forksheet transistor 70U is formed at the lower stack, as shown in FIG. 7D.

Referring to FIG. 7D, a 3D-stacked semiconductor device 80 may include a 1^{st} forksheet transistor 80L formed of PMOS nanosheet transistors 80LL and 80LR on a substrate 801 and a 2^{nd} forksheet transistor 80U formed of NMOS nanosheet transistors 80UL and 80UR, which are respectively stacked above the PMOS nanosheet transistors 80LL and 80LR with an MDI layer therebetween.

The 1^{st} forksheet transistor 80L may be the same as or correspond to the forksheet transistor 23 shown in FIG. 6, and the 2^{nd} forksheet transistor 80U may be the same as or correspond to the forksheet transistor 23 shown in FIG. 4A. In this case, both of a dielectric wall LW dividing channel layers 81C and 82C respectively surrounded by gate structures 81G and 82G and a dielectric wall UW dividing channel layers 83C and 84C respectively surrounded by gate structures 83G and 84G may be formed of a compressive material such as silicon oxide that can apply a tensile stress to the channel layers 81C, 82C, 83C and 84C of Si in the 2^{nd} direction D2 to improve carrier mobility.

Like the 3D-stacked semiconductor device 70, when the 3D-stacked semiconductor device 80 is manufactured, an initial channel structure for the channel layers 81C and 82C and an initial channel structure for the channel layers 83C and 84C may be epitaxially grown based on respective substrates in separate processes, and then, the two forksheet transistors 80L and 80R may be combined to form the 3D-stacked semiconductor device 80.

Although not shown in the drawings, a 3D-stacked semiconductor device may be formed of the forksheet transistor 23 of FIG. 4A and the forksheet transistor 23 of FIG. 4B at the lower stack and the upper stack, respectively, or vice versa, according to one or more other embodiments. In this 3D-stacked semiconductor device, a tensile stress applied to the channel layers 20C of the forksheet transistors 23 in the 2^{nd} direction D2 may also increase carrier mobility to improve device performance.

In the meantime, the foregoing forksheet transistor in which two nanosheet transistors of a same polarity type is divided by a dielectric wall including a compressive or tensile material may be used to form a semiconductor cell or standard cell to implement a logic circuit.

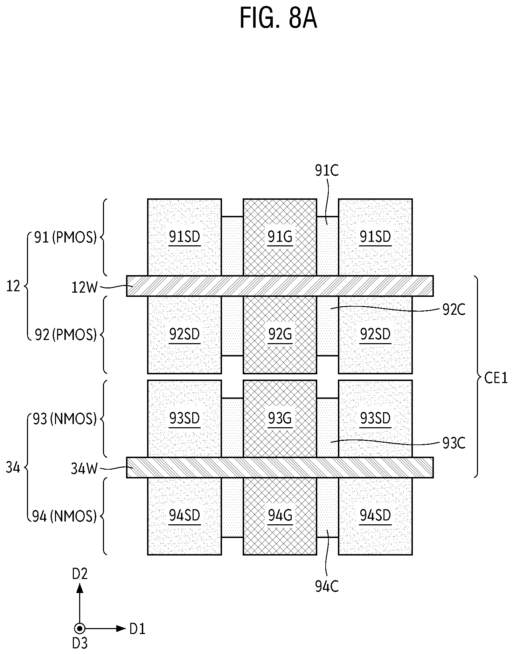

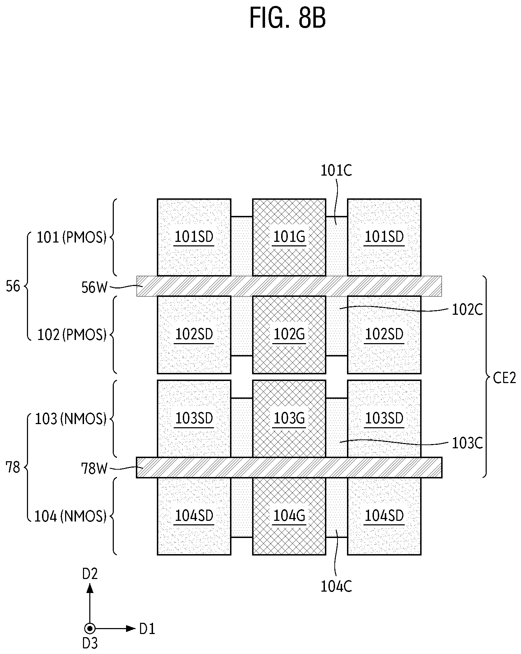

FIGS. 8A and 8B illustrates semiconductor cells each of which is formed of two forksheet transistors, according to one or more embodiments.

Referring to FIG. 8A, a semiconductor cell CE1 may include a PMOS nanosheet transistor 92 of a 1^{st} forksheet transistor 12 and an NMOS nanosheet transistor 93 of a 2^{nd} forksheet transistor 34 to implement a logic circuit such as a CMOS device. Since each of the 1^{st} forksheet transistor 12 and the 2^{nd} forksheet transistor 34 may be formed of two nanosheet transistors of a same polarity type, the PMOS nanosheet transistor 92 of the 1^{st} forksheet transistor 12 and the NMOS nanosheet transistor 93 of the 2^{nd} forksheet transistor 34 may be disposed to be next to each other in the 3^{rd} direction D3 to form a semiconductor cell CE1 for a CMOS device.

Thus, the semiconductor cell CE1 may be formed of a channel structure 92C, p-type source/drain patterns 92SD and a gate structure 92G of the 1^{st} forksheet transistor 12, and a channel structure 93C, n-type source/drain patterns 93SD and a gate structure 93G of the 2^{nd} forksheet transistor 34. The semiconductor cell CE1 may be bounded by a dielectric wall 12W of the 1^{st} forksheet transistor 12 as an upper boundary and a dielectric wall 34W of the 2^{nd} forksheet transistor 34 as a lower boundary.

In the semiconductor cell CE1, the 1^{st} forksheet transistor 12 may have the same structure and channel surface orientation as the forksheet transistor 23 shown in FIG. 6 and the 2^{nd} forksheet transistor 34 may have the same structure and the channel surface orientation as the forksheet transistor 23 shown in FIG. 5. Further, the dielectric walls 12W and 34W may have the same structures and materials or material compositions as the dielectric wall 23W shown in FIG. 6 and the dielectric wall 23W shown in FIG. 5, respectively. Thus, the channel structure 92C of the 1^{st} forksheet transistor 12 (PMOS) with a top surface and a side surface in the (110) orientation and the (100) orientation, respectively, may have a tensile stress in the 2^{nd} direction D2 to increase hole mobility by the dielectric wall 12W formed of a compressive material, and the channel structure 93C of the 2^{nd} forksheet transistor 34 (NMOS) with a top surface and a side surface in the same (110) direction and (100) direction, respectively, may have a compressive stress in the 2^{nd} direction D2 to increase electron mobility by the dielectric wall 34W formed of a tensile material.

In contrast, FIG. 8B shows a semiconductor cell CE2 including a PMOS nanosheet transistor 102 of a 1^{st} forksheet transistor 56 and an NMOS nanosheet transistor 103 of a 2^{nd} forksheet transistor 78 to implement a logic circuit such as a CMOS device. Since each of the 1^{st} forksheet transistor 56 and the 2^{nd} forksheet transistor 78 may be formed of two nanosheet transistors of a same polarity type, the PMOS nanosheet transistor 102 of the 1^{st} forksheet transistor 56 and the NMOS nanosheet transistor 103 of the 2^{nd} forksheet transistor 78 may be disposed to be next to each other in the 3^{rd} direction D3 to form a semiconductor cell CE2 for a CMOS device.

Thus, the semiconductor cell CE2 may be formed of a channel structure 102C, p-type source/drain patterns 102SD and a gate structure 102G of the 1^{st} forksheet transistor 56, and a channel structure 103C, n-type source/drain patterns 103SD and a gate structure 103G of the 2^{nd} forksheet transistor 78. The semiconductor cell CE2 may be bounded by a dielectric wall 56W of the 1^{st} forksheet transistor 56 as an upper boundary and a dielectric wall 78W of the 2^{nd} forksheet transistor 78 as a lower boundary.

In the semiconductor cell CE2, the 1^{st} forksheet transistor 56 may have the same structure and channel surface orientation as the forksheet transistor 23 shown in FIG. 6 and the 2^{nd} forksheet transistor 78 may have the same structure and the channel surface orientation as the forksheet transistor 23 shown in FIG. 4A. Further, the dielectric walls 56W and 78W may have the same structures and materials or material compositions as the dielectric wall 23W shown in FIG. 6 and the dielectric wall 23W shown in FIG. 4A, respectively. Thus, the channel structure 102C of the 1^{st} forksheet transistor 56 (PMOS) with a top surface and a side surface in the (110) direction and the (100) direction, respectively, may have a tensile stress in the 2^{nd} direction D2 to increase hole mobility by the dielectric wall 56W formed of a compressive material, and the channel structure 103C of the 2^{nd} forksheet transistor 78 (NMOS) with a top surface and a side surface in the same (100) orientation and (110) orientation, respectively, may have a compressive stress in the 2^{nd} direction D2 to increase electron mobility by the dielectric wall 78W formed of a compressive material.

Although not shown in the drawings, the two forksheet transistors forming a semiconductor cell may each be the forksheet transistor 23 shown in FIG. 4A and the forksheet transistor 23 shown in FIG. 4B, according to one or more other embodiments. A CMOS device in this semiconductor cell may be formed by one NMOS nanosheet transistor of the forksheet transistor 23 of FIG. 4A and one PMOS nanosheet transistor of the forksheet transistor 23 of FIG. 4B with the dielectric walls 23W of FIGS. 4A and 4B as a lower boundary and an upper boundary of the semiconductor cell, respectively.

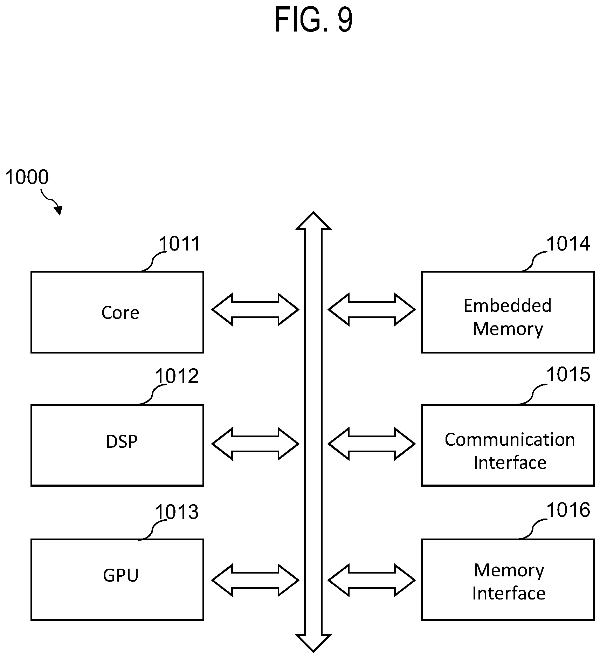

FIG. 9 is a schematic block diagram illustrating an electronic device including at least one of the forksheet transistors shown in FIGS. 2A, 2B, 3A, 3B, 4A, 4B, 5 and 6, the 3D-stacked semiconductor devices shown in FIGS. 7A-7D, and the semiconductor cells shown in FIGS. 8A and 8B, according to one or more embodiments.

Referring to FIG. 9, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (RAM) (DRAM), a flash memory, etc.

At least one of the core 1011, the DSP 1012, the GPU 1013, and/or the embedded memory 1014 may include at least one of the semiconductor devices described above.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} channel structure extended in a 1^{st} direction;
a 1^{st} source/drain pattern on the 1^{st} channel structure;
a 2^{nd} channel structure extended in the 1^{st} direction, wherein the 2^{nd} channel structure is disposed at a side of the 1^{st} channel structure in a 2^{nd} direction intersecting the 1^{st} direction;
a 2^{nd} source/drain pattern on the 2^{nd} channel structure; and
a 1^{st} dielectric wall between the 1^{st} channel structure and the 2^{nd} channel structure,
wherein the 1^{st} source/drain pattern and the 2^{nd} source/drain pattern are each of n-type,
wherein a top surface of each of the 1^{st} channel structure and the 2^{nd} channel structure is in a (110) orientation, and
wherein a side surface of each of the 1^{st} channel structure and the 2^{nd} channel structure is in a (100) orientation.

2. The semiconductor device of claim 1, wherein the 1^{st} dielectric wall comprises a material having a thermal expansion coefficient greater than a material forming the 1^{st} channel structure and the 2^{nd} channel structure.

3. The semiconductor device of claim 1 or 2, wherein the 1^{st} dielectric wall comprises a tensile material with respect to a material forming the 1^{st} channel structure and the 2^{nd} channel structure.

4. The semiconductor device of any one of claims 1 to 3, wherein the 1^{st} dielectric wall comprises silicon nitride, and
wherein each of the 1^{st} channel structure and the 2^{nd} channel structure comprises silicon.

5. The semiconductor device of any one of claims 1 to 4, wherein each of the 1^{st} channel structure and the 2^{nd} channel structure comprises a plurality of nanosheet layers.

6. The semiconductor device of any one of claims 1 to 5, further comprising:
a 3^{rd} channel structure extended in the 1^{st} direction, wherein the 3^{rd} channel structure is disposed above the 1^{st} channel structure in a 3^{rd} direction intersecting the 1^{st} direction and the 2^{nd} direction;
a 3^{rd} source/drain pattern on the 3^{rd} channel structure;
a 4^{th} channel structure extended in the 1^{st} direction, wherein the 4^{th} channel structure is disposed at a side of the 3^{rd} channel structure in the 2^{nd} direction;
a 4^{th} source/drain pattern on the 4^{th} channel structure; and
a 2^{nd} dielectric wall between the 3^{rd} channel structure and the 4^{th} channel structure,
wherein the 3^{rd} source/drain pattern and the 4^{th} source/drain pattern are each of p-type,
wherein a top surface of each of the 3^{rd} channel structure and the 4^{th} channel structure is in the (110) orientation, and
wherein a side surface of each of the 3^{rd} channel structure and the 4^{th} channel structure is in the (100) orientation.

7. The semiconductor device of claim 6, wherein the 2^{nd} dielectric wall comprises a material having a thermal expansion coefficient smaller than a material forming the 3^{rd} channel structure and the 4^{th} channel structure.

8. The semiconductor device of claim 6 or 7, wherein the 2^{nd} dielectric wall comprises a compressive material with respect to a material forming the 3^{rd} channel structure and the 4^{th} channel structure.

9. The semiconductor device of any one of claims 6 to 8,
wherein the 2^{nd} dielectric wall comprises silicon oxide, and
wherein each of the 3^{rd} channel structure and the 4^{th} channel structure comprises silicon.

10. The semiconductor device of any one of claims 6 to 9, wherein each of the 1^{st} channel structure, the 2^{nd} channel structure, the 3^{rd} channel structure, and the 4^{th} channel structure comprises a plurality of nanosheet layers.

11. A semiconductor device comprising:
a 1^{st} channel structure extended in a 1^{st} direction;
a 1^{st} source/drain pattern on the 1^{st} channel structure;
a 2^{nd} channel structure extended in the 1^{st} direction, wherein the 2^{nd} channel structure is disposed at a side of the 1^{st} channel structure in a 2^{nd} direction intersecting the 1^{st} direction;
a 2^{nd} source/drain pattern on the 2^{nd} channel structure; and
a dielectric wall between the 1^{st} channel structure and the 2^{nd} channel structure,
wherein the 1^{st} source/drain pattern and the 2^{nd} source/drain pattern are each of p-type,
wherein a top surface of each of the 1^{st} channel structure and the 2^{nd} channel structure is in a (100) orientation, and
wherein a side surface of each of the 1^{st} channel structure and the 2^{nd} channel structure is in a (110) orientation.

12. The semiconductor device of claim 11, wherein the dielectric wall comprises a material having a thermal expansion coefficient smaller than a material forming the 1^{st} channel structure and the 2^{nd} channel structure.

13. The semiconductor device of claim 11 or 12, wherein the dielectric wall comprises a compressive material with respect to a material forming the 1^{st} channel structure and the 2^{nd} channel structure.

14. The semiconductor device of any one of claims 11 to 13,
wherein the dielectric wall comprises silicon oxide, and
wherein each of the 1^{st} channel structure and the 2^{nd} channel structure comprises silicon.

15. The semiconductor device of any one of claims 11 to 14, wherein each of the 1^{st} channel structure and the 2^{nd} channel structure comprises a plurality of nanosheet layers.
